# EUROPÄISCHE PATENTANMELDUNG

(11) **EP 3 543 982 A1**
(43) Veröffentlichungstag der Anmeldung: **25.09.2019**
(21) Anmeldenummer: 19158576.9
(22) Anmeldetag: 21.02.2019
(51) Int. Cl.: G08B 17/00, G08B 25/10, H01Q 1/00, H01Q 1/22, H01Q 1/38, H05K 1/02

(54) **DRAHTLOSKOMPONENTE EINER BRANDSCHUTZ-FESTSTELLANLAGE ODER EINER BRANDMELDEANLAGE**

(30) Priorität: 20.03.2018 DE 102018204204
(71) Anmelder: GEZE GmbH, 71229 Leonberg (DE)
(72) Erfinder: Hucker, Matthias, 76359 Marxzell (DE); Luterotti, Lorenzo, 34072 (GO) Farra d´Isonzo (IT); Palminteri, Daniel, 76327 Pfinztal (DE)

(57) **Zusammenfassung**

Eine Drahtloskomponente (10) einer Brandschutz-Feststellanlage (100) oder Brandmeldeanlage hat eine eine erste Nachricht ausgebende Vorrichtung (12) und eine Funkschnittstelle (13, 14) mit einer Antenne (14) zum Aussenden elektromagnetischer Signale, auf die die erste Nachricht aufcodiert ist. Die Antenne (14) weist eine von einem Substrat (11) getragene Leiterstruktur (14) auf mit einem Versorgungspunkt (14a) zum Zuführen oder Abgreifen einer Signalspannung und davon ausgehend zwei Leiterbereichen (14b, 14d), deren erster (14d) an einer anderen Stelle (14e) geerdet ist und deren zweiter (14b) an seinem anderen Ende (14c) offen ist und mindestens teilweise gegenüber einer Erdleitung (13) verläuft.

## Beschreibung

Die Erfindung betrifft eine Drahtloskomponente einer Brandschutz-Feststellanlage oder einer Brandmeldeanlage.

Bezug nehmend auf Fig. 4 wird zunächst allgemein eine Feststellanlage 100 beschrieben, wie sie aus der DE 102014225297 B4 bekannt ist. In Fig. 4 beschreiben Pfeile zwischen Kästchen Funkstrecken, während Linien verdrahtete Verbindungen darstellen. 112 sind zwei drahtlose Brandsensoren, und 114 ist ein Handauslösetaster. Brandmelder können Brandbedingungen, etwa Rauch oder bestimmte Gase und womöglich auch Strahlung detektieren und ein entsprechendes Alarmsignal abgeben. Die Signalabgabe erfolgt über die gezeigte Funkstrecke. Über einen Handauslösetaster 114 kann ein qualitativ gleicher Alarm ausgelöst werden, der ebenso über eine Funkstrecke übertragen wird.

Mit 126 ist eine Kommunikationsschnittstelle bezeichnet, die mit den peripheren Funkkomponenten drahtloser Brandmelder 112 und Handauslösetaster 114 (nachfolgend auch nur als "periphere Komponenten" angesprochen) die Funkkommunikation ermöglicht. Die kommunikationsschnittstelle 126 wird auch als "Zentralkomponente" angesprochen. Die Kommunikation ist vorzugsweise bidirektional. Dann sind alle Komponenten 112, 114 und 126 sendend und empfangend.

Zur Handhabung der mehreren Kanäle kann ein geeignetes Multiplex implementiert sein. Hardwareseitig kann es durch Schalter definiert werden. Funkseitig werden Zugriffskonflikte kaum auftreten, da die Signalisierungszeiten sehr kurz im Vergleich zu den Zykluszeiten sind (Faktor < 10⁻⁶). Wenn dennoch ein unwahrscheinlicher Zugriffskonflikt entsteht, sind geeignete Neuversenderoutinen implementiert, damit Nachrichten nicht verloren gehen. Die peripher sendenden Komponenten drahtloser Brandmelder und Handauslösetaster können Identifizierungsdaten mitsenden, so dass in der Kommunikationsschnittstelle 126 erkannt werden kann, von welcher Komponente die jeweilige Sendung kommt.

128 ist ein Widerstandssimulationsmittel, mittels dessen in einer Komponente, insbesondere einer zentralen Komponente, Fehlersituationen simuliert werden können, die eine andere funkende Komponente 112 oder 114 (Drahtloskomponenten) betreffen. Unter "Komponente" kann dabei ein eigenständig montierbarer oder aufsteckbarer Anlagenteil verstanden werden. Eine "Funkkomponente" oder "Drahtloskomponente" kann eine Komponente sein, die über eine Funkstrecke an eine andere Komponente Informationen sendet und/oder von dieser empfängt. Verdrahtete Komponenten erkennen ihre Verbindung anhand einer Widerstandsüberwachung. Widerstand sehr hoch oder unendlich oder Widerstand sehr klein oder praktisch 0 bedeuten Fehler im Sinne einer Leitungsunterbrechung oder eines Kurzschlusses, während Widerstände in einem mittleren Bereich eine ordnungsgemäße Verbindung kennzeichnen. Dies wird von der überwachenden Komponente überprüft. Damit eine überwachende Komponente für angekoppelte Funkkomponenten die gleichen Überwachungsroutinen laufen lassen kann wie für festverdrahtete Komponenten, ist an der überwachungsseitigen Funkschnittstelle 126 ein Widerstandssimulationsmittel 128 vorgesehen. Wenn der Signalaustausch über die Funkstrecke an der Funkschnittstelle 126 ergibt, dass ein Funk-Konnektivitätsproblem oder auch ein sonstiges Problem in der angekoppelten Funkkomponente vorliegt, kann das Widerstandssimulationsmittel 128 (gesteuert durch die Funkschnittstelle oder eigene Logik) dazu verwendet werden, dieses Problem so zu signalisieren, wie es ein Leitungsbruch oder Kurzschluss einer festverdrahteten Komponente tun würde. Die Kommunikationsschnittstelle 126 und das Widerstandssimulationsmittel 128 können zu einem Zusatzmodul 124 zusammengefasst sein. Das Zusatzmodul 124 ist an eine Steuer- und/oder Auswerteeinrichtung 118 (nachfolgend auch kurz Steuerung 118 bezeichnet) angeschlossen. Der Anschluss kann durch ein unmittelbares Aufstecken des Moduls auf die Einrichtung 118 erfolgen oder mittels einer länglichen Leitung. Genauso gut ist es aber möglich, die Kommunikationsschnittstelle 126 und das Widerstandssimulationsmittel 128 integral mit der Steuerung 118 vorzusehen. 116 ist eine Energieversorgung für die fest verdrahteten Komponenten.

120 ist eine Feststellvorrichtung mit Auslösevorrichtung. Sie löst auf das Vorliegen vorbestimmter Bedingungen hin eine mechanische Maßnahme aus. Regelmäßig ist dies das Veranlassen eines Türschlusses oder eines Torschlusses. Die Maßnahme erfolgt planmäßig dann, wenn der drahtlose Brandmelder 112 oder der Handauslösetaster 114 ein entsprechendes Signal zunächst über die Funkstrecke an die Kommunikationsschnittstelle 126 übertragen hat, die es mindestens an die Steuerung 118 weiterleitet und die dann die nötigen Veranlassungen trifft.

Um die Konnektivität zwischen den funkenden Komponenten 112 bzw. 114 und der Kommunikationsschnittstelle 126 zu überwachen, ist neben der Mitteilung von Alarmen eine regelmäßige bzw. periodische Kommunikation zwischen ihnen implementiert. Wenn sie nicht oder nicht wie vorgesehen stattfindet, werden geeignete Maßnahmen ausgelöst. Die regelmäßige Kommunikation über die Funkstrecken ist so gestaltet, dass sie von der peripheren Komponente drahtloser Brandmelder 112 oder Handauslösetaster 114 periodisch gestartet wird. Es wird dann eine Nachricht (nachfolgend "Verbindungstestnachricht" genannt) von der peripheren Komponente an die Kommunikationsschnittstelle 126 gesendet, von der es rückwärts zur peripheren Komponente hin quittiert wird (was nachfolgend als "Quittungsnachricht" bezeichnet wird). Die Periodendauer dieser Tests liegt unter 100 Sekunden, vorzugsweise unter 80 oder unter 70 Sekunden. Sie kann über 40 oder über 50 Sekunden liegen.

Die Verbindungstestnachricht selbst dauert nur wenige Millisekunden, gleiches gilt für die Quittungsnachricht, die nach Empfang der Verbindungstestnachricht zurück zur peripheren Komponente gesendet wird. Wenn die Steuerung 118 nicht die erwartete Verbindungstestnachricht im vorgesehen Zeitfenster erhält, werden weitere Maßnahmen veranlasst, was auch die Anforderung menschlichen Eingreifens umfassen kann. Wenn wiederum die periphere Komponente 112, 114 nicht die erwartete Quittungsnachricht erhält, können auch hier weitere Maßnahmen getroffen werden, etwa Neuversuch der Verbindungstestnachricht, gegebenenfalls mit anderen Parametern (höhere Sendeleistung), lokale oder entfernte Fehlerbenachrichtigung und ähnliches.

Die zentrale und die peripheren Komponenten benötigen also fortwährend Kommunikation untereinander, sei es zum Zwecke des Selbsttests auf Konnektivität und ordentliche Funktion oder sei es der Primärzweck der Alarmweiterleitung und Alarmgenerierung. Es hat sich dabei als Problem erwiesen, die Funkschnittstellen mit geeigneten Antennen auszustatten. Dies gilt für die zentralen Komponenten (z. B. Kommunikationsschnittstelle 126) wie für die peripheren Komponenten (Brandmelder 112, Handauslösetaster 114) des Systems. Solche Gerätschaften befinden sich häufig in Umgebungen mit starkem Publikumsverkehr, etwa Schulen, Behörden, Verwaltungsgebäude und ähnliches. Sie sind deshalb teils unbeabsichtigten, teils aber auch beabsichtigten Beeinflussungen bis hin zu Vandalismus ausgesetzt. Es ist deshalb nicht möglich, diese Gerätschaften zuverlässig mit herkömmlichen Stabantennen auszustatten, da diese in der Regel nur eine kurze Lebensdauer haben und danach das Gerät unbrauchbar bzw. reparaturbedürftig machen.

Aufgabe der Erfindung ist es, eine zuverlässige, klein bauende und billig herzustellende Antenne für Drahtloskomponenten einer Funkfeststellanlage oder einer Funkbrandmeldeanlage anzugeben.

Diese Aufgabe wird mit den Merkmalen der unabhängigen Patentansprüche gelöst.

Angegeben wird eine Drahtloskomponente einer Brandschutz-Feststellanlage oder einer Brandmeldeanlage mit einer Nachrichten aussendenden Vorrichtung und einer Funkschnittstelle mit einer Antenne zum Aussenden elektromagnetischer Signale, auf die die gewünschte Nachricht aufcodiert ist. Die Antenne weist eine von einem Substrat getragene Leiterstruktur auf. Sie hat einen Versorgungspunkt zum Zuführen oder Abführen zu sendender bzw. empfangener Signale. Vom Versorgungspunkt gehen zwei Leiterbereiche aus. Deren erster ist an einer anderen Stelle, vorzugsweise an seinem anderen Ende, geerdet. Der zweite, deutlich längere ist an seinem anderen Ende offen und läuft mindestens längs eines Teils seiner Länge gegenüber einer Erdleitung.

Es hat sich gezeigt, dass solche Antennen vergleichsweise klein und günstig gebaut werden können. Sie können eingehäust werden und teilweise sogar auf und/oder über den sonstigen Platinen der involvierten Schaltungen ausgebildet werden. Sie sind deshalb besser gegen Einflüsse von außen wie unbeabsichtigte Beeinflussung oder Vandalismus geschützt.

Die die Antenne nützende Funkschnittstelle kann eine bidirektionale Funkschnittstelle zum Senden und/oder Empfangen von Nachrichten unter Verwendung der Antenne sein.

Leiterstruktur und/oder die gegenüberliegende Erdleitung können ganz oder teilweise auf dem Substrat liegen oder mit Abstand und parallel dazu verlaufen. Das Antennensubstrat kann eine Leiterplatte sein oder ein Teil eines Gehäuses der Komponente oder eine Fläche der Einbauumgebung der Komponente.

Der erste Leiterbereich und der zweite Leiterbereich können winklig zueinander stehen bzw. durch Kanten begrenzt sein, die am Versorgungspunkt einen Winkel einschließen, der in etwa rechtwinklig ist. Der zweite Leiterbereich kann so geformt sein, dass er zu einem freien Ende hin laufend zurück zum Versorgungspunkt der Antenne gekrümmt ist, ohne jedoch mit ihm verbunden zu sein, so dass das freie Ende zuletzt dem Versorgungspunkt mit geringem Abstand gegenüber liegt. Vorzugsweise ist die Erdleitung auf dem Substrat ausgebildet und ist die Leiterstruktur mit Abstand über dem Substrat gehalten.

Nachfolgend werden Bezug nehmend auf die Zeichnungen einzelne Ausführungsformen der Erfindung beschrieben, es zeigen
- Fig. 1: eine schematische Darstellung der Drahtloskomponente,
- Fig. 2: eine schematische Darstellung einer Antenne,
- Fig. 3: eine weitere schematische Darstellung einer Antenne, und
- Fig. 4: eine bekannte Feststellanlage.

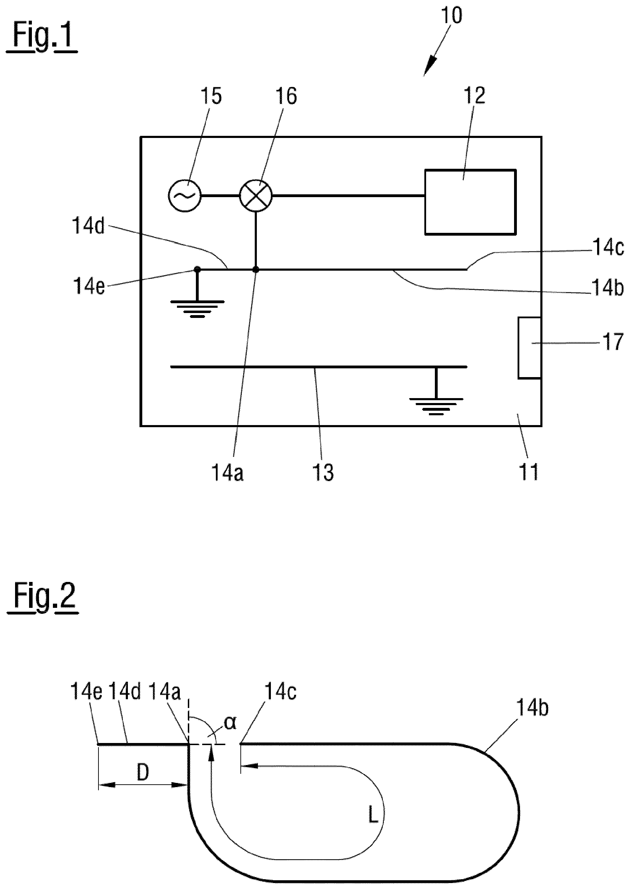

In Fig. 1 zeigt 10 allgemein eine Drahtloskomponente. Es kann sich bei ihr beispielsweise um einen Drahtlos-Brandsensor handeln oder um eine Kommunikationsschnittstelle. Die Komponente weist ein Substrat 11 auf, auf dem die Bauelemente der Komponente angeordnet sind. Mit 12 sind allgemein die funktionsgebenden Bauteile der Komponente beschrieben, also etwa Brandsensor, Handtaster, Signalauswertung, Ablaufsteuerung, Signalwandelung, Logistiksteuerung innerhalb der Komponente etc. Die Funkschnittstelle der Komponente weist einen Oszillator 15 auf, einen Modulator 16 und eine Antenne 14. Gegebenenfalls kann eine Masseleitung 13 auch als Teil der Antenne angesehen werden. Mit 17 ist ein Anschluss der Komponente gezeigt, mit der die Komponente an andere Systemkomponenten leitungsgebunden verbunden werden kann.

Die Antenne 14 weist eine Leiterstruktur mit mehreren elektrisch miteinander verbundenen Leiterbereichen auf. Der Modulator 16 empfängt das Trägersignal vom Oszillator 15 und das Datensignal aus der Schaltung 12 und erzeugt ein dementsprechendes Signal zum Einspeisen am Versorgungspunkt 14a der Antenne. Sinngemäß umgekehrt ist der Signalfluss beim Empfangen von Signalen. Dann werden empfangene Signale/Spannungen am Versorgungspunkt 14a abgegriffen und über Modulator/Demodulator 16 der Schaltung zugeführt.

Vom Versorgungspunkt 14a gehen zwei Leiterbereiche 14d und 14b ab. Der erste Leiterbereich 14d ist an einer anderen Stelle, vorzugsweise seinem anderen Ende, soweit er länglich ausgebildet ist, geerdet. Der zweite Leitungsbereich 14b verläuft frei und nicht weiter elektrisch kontaktiert. Elektrisch betrachtet hat er eine Längsrichtung mit einem freien Ende 14c. Der zweite Leiterbereich 14b liegt ganz oder teilweise gegenüber einer Erdleitung 13. Auch der erste Leiterbereich 14d kann ganz oder teilweise gegenüber der Erdleitung 13 liegen.

Es hat sich gezeigt, dass Antennen dieser qualitativen Bauart hinreichend kräftig sendend und empfangend ausgebildet werden können und dabei hinreichend klein sind, damit sie eingehäust verbaut werden können und so Beeinflussungen aus der Umgebung entzogen sind.

Als Substrat für die Antenne 14 kann die Leiterplatte der sonstigen Schaltung der Drahtloskomponente 10 verwendet werden oder es kann eine andere Fläche verwendet werden, etwa eine Gehäuseinnenfläche oder eine sonst geeignete zugängliche Fläche am Verbauort.

In der Ausführungsform der Fig. 2 schließen am Versorgungspunkt 14a geradlinige Kanten K8, K1, die den ersten Leiterbereich 14d und den zweiten Leiterbereich 14b begrenzen, einen Winkel α ein, der in etwa rechtwinklig ist oder der, allgemeiner ausgedrückt, kleiner ist als 110° oder kleiner als 100° oder kleiner als 93°, wobei er größer als 70° sein kann oder größer als 80° oder größer als 87°, und insbesondere 90° sein kann.

Weiter zeigt die Fig. 2 eine Ausführungsform, bei der der zweite Leiterbereich 14b so gekrümmt ist, dass er in Richtung zum freien Ende 14c gehend zurück zum Versorgungspunkt 14a führt, ohne mit jedem jedoch direkt elektrisch verbunden zu sein. Die elektrische Verbindung des freien Endes 14c erfolgt durch den zweiten Leiterbereich 14b.

Mit den genannten Gestaltungen kann die absolute Größe des Antennenaufbaus vergleichweise klein gehalten werden. Gesamtlänge (in Links-Rechts-Richtung in Fig. 2) und -breite (oben-unten in Fig. 2), können unter 5 cm bzw. unter 1,5 cm liegen.

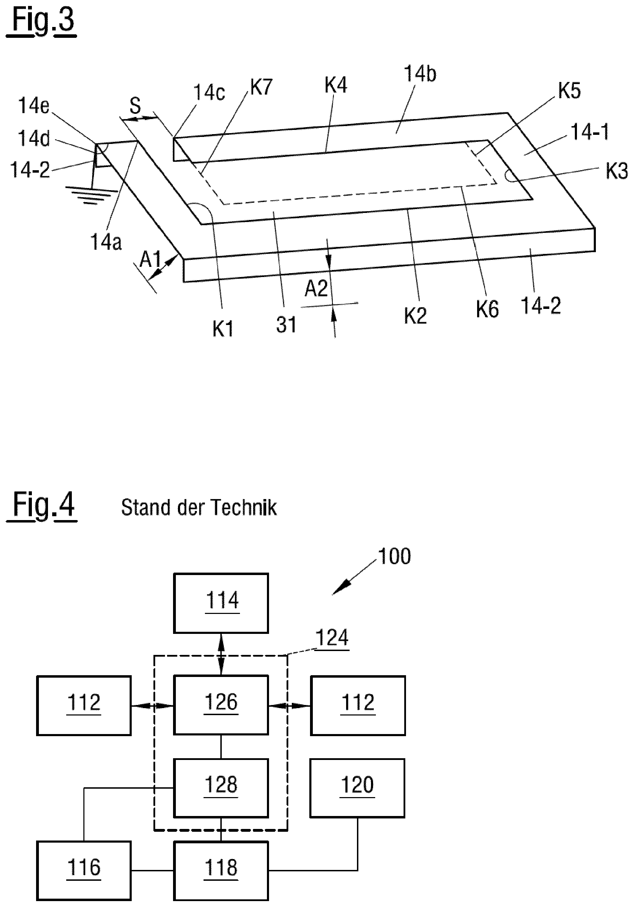

Fig. 3 zeigt schematisch eine Ausführungsform der Antenne ähnlich der der Fig. 2. Es wird angenommen, dass dieser Aufbau über einer Substratoberfläche mechanisch gehalten ist, wobei die Fig. 3 die mechanische Halterung nicht zeigt. Sie kann in geeigneter Weise gebaut werden, etwa durch elektrisch nicht angeschlossene Beinchen am Antennenmaterial (nicht gezeigt) oder durch eine geeignete Fassung (nicht gezeigt) oder ähnliches.

Mit A1 ist die Höhe der Antennen-Leiterstruktur über der Substratoberfläche bezeichnet. Fig. 3 zeigt eine Ausführungsform, bei der die Leiterstruktur der Antenne 14 aus Blech geeigneter Dicke hergestellt ist. Am rechten Eck des linken Endes der Leiterschleife findet sich der Versorgungspunkt 14a. Der Erdungspunkt des ersten Leiterbereichs 14d ist die linke Ecke des linken Endes der Leiterschleife. Der erste Leiterbereich 14d ist dementsprechend die Metallisierung, die zwischen diesen beiden Punkten wirksam ist. Der zweite Leiterbereich 14b ist durch die große Schleife gebildet. Seine Länge wird in der gezeigten Ausführungsform durch die Kanten K1, K2, K3 und K4 wesentlich bestimmt.

Das freie Ende des zweiten Leiterbereichs 14b liegt am oberen Eck des rechten Endes der Leiterschleife gar nicht weit vom Versorgungspunkt 14a beabstandet. Der Spalt zwischen ihnen kann eine Breite S haben, die kleiner als 3 mm oder kleiner 2 mm ist. Auf dem Substrat selbst und damit mit Abstand A1 bzw. A2 von der Leiterstruktur 14 der Antenne läuft eine geerdete Leitung oder liegt eine geerdete Schicht. Unter den zwei Leiterbereichen 14b und 14d liegt mindestens teilweise, vorzugsweise vollständig diese Erdleitung. Vorzugsweise handelt es sich um eine flächige geerdete Leiterschicht.

Die Antenne hat, wie in Fig. 3 schematisch gezeigt eine im Wesentlichen rechteckige Kontur. Längs der Längskanten (parallel zu K2 und K4) sind an den Außenkanten Bereiche nach unten abgewinkelt, also auf die Erdung zu, und halten an deren unterer Kante den schon genannten Abstand A2 zum Substrat bzw. zur geerdeten Leitung/Fläche.

Statt der Innenkante K4 des distalen Endes des zweiten Leiterbereichs 14b kann auch ein metallischer Vorsprung vorgesehen sein, der sich auf den gegenüberliegenden Leiterbereich (bei K2) zu erstreckt und der von den gestrichelt angedeuteten Kanten K5, K6 und K7 umgrenzt ist. Diese Kanten liegen so, dass sich letztendlich ein hakenförmiger Spalt mit in etwa gleichförmiger Breite entsprechend dem Abstand S durch die obere Fläche 14-1 der Antenne zieht, wobei die Kanten K1, K2 und K3 die Außenkontur dieses "Hakens" bilden. Die Kante K1 kann eine Länge in einem Bereich von 9 mm ± 10% oder ± 5% haben. Die Kante K2 kann eine Länge in einem Bereich von 23,5 mm ± 10% oder ± 5% haben. Die Kante K3 kann eine Länge in einem Bereich von 7 mm ± 10% oder ± 5% haben. Die Kanten K1 bis K8 können jeweils geradlinig verlaufen. Die Kanten K1 bis K8 können zwischen sich jeweils, in der Zeichnungsebene der Figur 3 betrachtet, einen Innen- bzw. Außenwinkel von 90° ± 10% oder ± 5% oder ± 2% oder ± 1% oder genau 90° einschließen.

Die Gesamtabmessungen der Antenne können so sein, dass ihre Länge (links-rechts in Fig. 3) unter 40 mm oder unter 35 mm liegt und/oder über 30 oder über 33 mm, ihre Breite (parallel zu K1 in Fig. 3) unter 15 oder unter 12 mm liegt und über 10 mm oder über 11 mm liegt, und ihre Bauhöhe über dem Substrat (parallel zu A1) dem Abstand A1 entspricht.

Die Drahtloskomponente kann ein elektromagnetisch permeables Gehäuse aufweisen oder ein Gehäuse mit elektromagnetisch permeablen Gehäusebereichen. Auf der Innenseite dieser Gehäusebereiche oder gering beabstandet darunter (im Gehäuseinneren) kann die Leiterstruktur der Antenne zu liegen kommen. Auch kann das Gehäuse selbst, insbesondere dessen elektromagnetisch permeablen Bereiche, das Trägersubstrat der Antenne bilden. Die genannte Erdleitung bzw. Erdungsschicht 13 ist dann gegebenenfalls so zu positionieren, dass die Abstrahlung in die gewünschte Richtung (weg vom Gehäuse) nicht behindert wird, also vorzugsweise gehäuseeinwärts beabstandet.

Andererseits ist es möglich, Gehäuseteile elektrisch leitend auszubilden und diese dann entsprechend der beschriebenen Leiterstruktur der Antenne zu gestalten, von übrigen Gehäuseteilen geeignet zu isolieren und an die Treiberschaltung geeignet anzuschließen. Auch möglich ist es, die für die Leiterstruktur der Antenne 14 nötigen Leiter durch Aufkleben leitender Bereiche auf eine Fläche, beispielsweise einen elektrisch isolierenden, magnetisch ggf. permeablen Bereich eines Gehäuses, zu erzeugen. Dies gilt sowohl für die eigentlichen Antennenleiter wie auch für die Erdleiter. Die so positionierten Strukturen müssen dann noch mit der übrigen Schaltung verdrahtet werden. Dies kann durch Stecker oder ähnliches geschehen.

Ein flächiger Teil 14-1 der Leiterstruktur 14 kann in einer Dimension (also zylindersegmentförmig) oder in zwei Dimensionen (kugelsegmentförmig) gekrümmt ausgebildet sein. Der Krümmungsradius kann über 10 mm oder über 20 mm oder über 30 mm liegen.

Die Länge L des zweiten Leiterbereichs 14b zwischen Versorgungspunkt 14a und seinem offenen Ende 14c und der Abstand D zwischen Versorgungspunkt 14a und Erdungsstelle 14e des ersten Leiterbereichs 14d können ein numerisches Verhältnis v = L/D haben, das größer als 11 oder größer als 12 ist und das kleiner als 15 oder kleiner als 14 ist. Die Gesamtlänge der Kanten K1 bis K4 (also Längen entsprechend K1 + K2 + K3 + K4) kann zwischen 60 mm und 70 mm liegen, insbesondere zwischen 62 und 66 mm. Die erste Innenkante K1 kann eine Länge haben, die mit der Länge der zweiten Innenkante K2 ein Verhältnis einschließt, das größer als 0,3 oder größer als 0,35 ist und das kleiner als 0,5 oder kleiner als 0,45 ist.

Die Antenne kann für eine Sende- und Empfangsfrequenz zwischen 865 MHz und 870 Mhz, insbesondere von etwa 868 MHz ausgelegt sein.

Merkmale, die in dieser Beschreibung dargestellt sind, sollen auch dann als miteinander kombinierbar angesehen werden, wenn ihre Kombination nicht explizit beschrieben ist. Merkmale, die in einem gewissen Kontext oder Patentanspruch oder in einer Figur oder einer Ausführungsform beschrieben sind, sollen auch als aus diesen heraus lösbar verstanden werden und sollen, soweit technisch möglich, als mit anderen Kontexten, Patentansprüchen, Figuren und Ausführungsformen kombinierbar verstanden werden, soweit dies technisch möglich ist.

### Bezugszeichenliste

- 10: Drahtloskomponente
- 11: Substrat
- 12: Schaltung
- 13: Erdleitung
- 14: Leiterstruktur
- 14a: Versorgungspunkt
- 14b: zweiter Leiterbereich
- 14c: freies Ende
- 14d: erster Leiterbereich
- 14e: Erdungspunkt
- 15: Oszillator
- 16: Modulator
- 17: Anschluss
- 14-1: erster Bereich
- 14-2: zweiter Bereich
- 31: Spalt
- 100: Feststellanlage, Brandmeldeanlage
- 112: drahtloser Brandmelder
- 114: Handauslösetaster
- 116: Energieversorgung
- 118: Steuerung
- 120: Feststellvorrichtung mit Auslösevorrichtung
- 124: Zusatzmodul
- 126: Kommunikationsschnittstelle
- 128: Widerstandssimulationsmittel
- K1 - K8: Kanten
- α: Winkel zwischen Kanten K1 und K8

## Patentansprüche

1. Drahtloskomponente (10) einer Brandschutz-Feststellanlage (100) oder Brandmeldeanlage, mit
einer eine erste Nachricht ausgebenden Vorrichtung (12), und
einer Funkschnittstelle (13, 14) mit einer Antenne (14) zum Aussenden elektromagnetischer Signale, auf die die erste Nachricht aufcodiert ist,
**dadurch gekennzeichnet, dass**
die Antenne (14) eine von einem Substrat (11) getragene Leiterstruktur (14) aufweist mit einem Versorgungspunkt (14a) zum Zuführen oder Abgreifen einer Signalspannung und davon ausgehend zwei Leiterbereichen (14b, 14d), deren erster (14d) an einer anderen Stelle (14e) geerdet ist und deren zweiter (14b) an seinem anderen Ende (14c) offen ist und mindestens teilweise gegenüber einer Erdleitung (13) verläuft.

2. Drahtloskomponente nach Anspruch 1, bei der am Versorgungspunkt (14a) der erste Leiterbereich (14d) und der zweite Leiterbereich (14b) durch Kanten (K1, K8) begrenzt sind, die einen Winkel (α) einschließen, der kleiner als 110° oder kleiner als 100° oder kleiner als 93° ist und der größer als 70° oder größer als 80° oder größer als 87° ist, insbesondere 90°.

3. Drahtloskomponente (10) nach Anspruch 1 oder 2, bei der die Funkschnittstelle (13, 14) eine bidirektionale Funkschnittstelle (13, 14) ist und zum Empfangen einer zweiten Nachricht nach dem Versenden der ersten Nachricht über die Antenne der Funkschnittstelle ausgelegt ist.

4. Drahtloskomponente nach einem der vorherigen Ansprüche, bei der die Leiterstruktur (14a-e) und/oder die Erdleitung (13) ganz oder teilweise auf dem Antennensubstrat (11) liegen oder mit Abstand dazu parallel dazu verlaufen.

5. Drahtloskomponente nach einem der vorherigen Ansprüche, bei der das Antennensubstrat (11) eine Leiterplatte oder ein Teil eines Gehäuses der Komponente oder eine Fläche der Einbauumgebung der Komponente ist.

6. Drahtloskomponente nach einem der vorherigen Ansprüche, mit einem Gehäuse, das einen elektromagnetisch permeablen Bereich aufweist, der die Leiterstruktur (14) und/oder die Erdleitung (13) trägt oder unter dem die Leiterstruktur positioniert ist.

7. Drahtloskomponente nach einem der vorherigen Ansprüche, bei der der zweite Leiterbereich (14b) derart gekrümmt ist, dass er schleifenartig zum Versorgungspunkt (14a) zurückläuft, wobei sein freies Ende (14c) nicht direkt mit dem Versorgungspunkt (14a) verbunden ist und deren Abstand kleiner 3 mm oder kleiner 2 mm ist.

8. Drahtloskomponente nach einem der vorherigen Ansprüche, bei der die Länge (L) des zweiten Leiterbereichs (14b) zwischen Versorgungspunkt (14a) und seinem offenen Ende (14c) und der.Abstand (D) zwischen Versorgungspunkt (14a) und Erdungsstelle (14e) des ersten Leiterbereichs (14d) ein numerisches Verhältnis (v = L/D) haben, das größer 11 oder größer 12 ist und das kleiner 15 oder kleiner 14 ist.

9. Drahtloskomponente nach einem der vorherigen Ansprüche, bei der der Abstand (D) zwischen Versorgungspunkt (14a) und Erdungsstelle (14e) des ersten Leiterbereichs (14d) kleiner 7 mm oder kleiner 6 mm ist und größer als 3 mm oder größer als 4 mm sein kann.

10. Drahtloskomponente nach einem der vorherigen Ansprüche, bei der die Erdleitung (13) auf dem Substrat ausgebildet ist und die Leiterstruktur (14) mit Abstand (A, A1, A2) über dem Substrat gehalten ist,

11. Drahtloskomponente nach Anspruch 10, bei der für erste Bereiche (14-1) der Leiterstruktur (14) der Abstand (A1) größer 3 mm oder größer 4 mm ist und kleiner 7 mm oder kleiner 6 mm ist.

12. Drahtloskomponente nach Anspruch 11, bei der für zweite Bereiche (14-2) der Leiterstruktur (14) der Abstand (A2) größer 1 mm oder größer 2 mm ist und kleiner 4 mm oder kleiner 3 mm ist.

13. Drahtloskomponente nach Anspruch 12, bei der die ersten Bereiche (14-1) flächig ausgebildet sind und die zweiten Bereiche (14-1) auf die Erdleitung (13) zu gebogene Kanten der ersten Bereiche sind.

14. Drahtloskomponente nach Anspruch 7, bei der die Schleife in Form eines Rechtecks ausgebildet ist, dessen erste zwei Innenkanten (K1, K2) ausgehend vom Versorgungspunkt (14a) ein Längenverhältnis (LK1/LK2) haben, das größer als 0,3 oder größer als 0,35 ist und das kleiner als 0,5 oder kleiner als 0,45 sein kann.

15. Drahtloskomponente nach einem der vorherigen Ansprüche, mit einem Gehäuse, wobei ein elektrisch leitender Teil des Gehäuses die Leiterstruktur (14) der Antenne bildet.

16. Drahtloskomponente nach einem der vorherigen Ansprüche, wobei ein flächiger Teil (14-1) der Leiterstruktur (14) in einer Dimension gekrümmt ausgebildet ist.

17. Drahtloskomponente nach einem der vorherigen Ansprüche, bei der die Leiterstruktur (14) und/oder die Erdleitung (13) auf das Substrat aufgeklebt ist.
